# EUROPEAN PATENT APPLICATION

(11) **EP 4 756 600 A1**
(43) Date of publication of application: **10.06.2026**
(21) Application number: 25185416.2
(22) Date of filing: 26.06.2025
(51) Int. Cl.: G06F 3/06

(54) **HYPER STORAGE DEVICE AND OPERATION METHOD OF MEMORY DEVICE INCLUDED THEREIN**

(30) Priority: 03.12.2024 KR 20240177928
(71) Applicant: Samsung Electronics Co., Ltd., Suwon-si, Gyeonggi-do 16677 (KR)
(72) Inventor: LEE, Seunghan, 16677 Suwon-si, Gyeonggi-do (KR); HA, Seungjun, 16677 Suwon-si, Gyeonggi-do (KR)
(74) Representative: Kuhnen & Wacker Patent- und Rechtsanwaltsbüro PartG mbB

(57) **Abstract**

A hyper storage device (100) is provided. The hyper storage device (100) is configured to communicate with a host device (10) executing a plurality of applications (APP1-APPn), and includes: an operation management circuit (110) configured to receive a plurality of data (DT) from the host device (10); a memory device (120) including a plurality of memory areas, and an application classifying circuit configured to control the plurality of data (DT) to be distributed to the plurality of memory areas based on a source application of each of the plurality of data (DT); and one or more storage devices (130) including a plurality of storage areas respectively corresponding to the plurality of memory areas. The memory device (120) is configured to flush a first memory area, which is one of the plurality of memory areas, to a first storage area, which is one of the plurality of storage areas and corresponds to the first memory area.

## Description

### BACKGROUND

### Field

The present disclosure relates to a semiconductor hyper storage device. More specifically, the present disclosure relates to a hyper storage device and an operation method of a memory device included therein.

### Related Art

As various technologies require large amounts of data, such as cloud services, video data storage, data analysis, and artificial intelligence model training, hyper storage devices that are configured to store large amounts of data are being researched. A hyper storage device may include one or more storage devices. Each of the one or more storage devices may include one or more storage areas.

The hyper storage device may sequentially store a plurality of data issued from a plurality of applications running on a host device in the one or more storage devices in an order of which the plurality of data is received. In this case, the plurality of data may be stored in an unorganized form on the one or more storage devices. For example, depending on the order in which the plurality of data are received, two or more data issued from single application running on the host device may be distributed in different storage areas, or the plurality of data issued from different applications running on the host device may be stored in one storage area. In this case, the operational efficiency of the hyper storage device may be reduced.

### SUMMARY

One or more example embodiments provide a hyper storage device in which a storage area where data to be stored is determined according to a source application of the received data, and an operation method of a memory device included therein.

According to an aspect of an example embodiment a hyper storage device configured to communicate with a host device executing a plurality of applications, includes: an operation management circuit configured to receive a plurality of data from the host device; a memory device including a plurality of memory areas, and an application classifying circuit configured to control the plurality of data to be distributed to the plurality of memory areas based on a source application of each of the plurality of data; and one or more storage devices including a plurality of storage areas respectively corresponding to the plurality of memory areas. The memory device is configured to flush a first memory area, which is one of the plurality of memory areas, to a first storage area, which is one of the plurality of storage areas and corresponds to the first memory area.

According to another aspect of an example embodiment an operation method of a memory device, includes: receiving a first data; identifying a source application of the first data, wherein the source application is identified from among a plurality of source applications; storing the first data in a first memory area among a plurality of memory areas determined based on the source application, wherein the plurality of source applications respectively correspond to the plurality of memory areas; and flushing the first memory area to an external storage device.

According to another aspect of an example embodiment a hyper storage device configured to store first data and second data provided from an external host device, includes: a storage device including a first storage area and a second storage area; and a memory device including a first memory area corresponding to the first storage area and a second memory area corresponding to the second storage area, wherein the memory device is configured to: buffer the first data in the first memory area based on identifying the first data is issued from a first application of the external host device; and buffer the second data in the second memory area based on identifying the second data is issued from a second application of the external host device.

### BRIEF DESCRIPTION OF DRAWINGS

The above and other aspects and features will be more apparent from the following description of example embodiments with reference to the attached drawings, in which:
FIG. 1 is a block diagram showing a storage system according to an example embodiment.
FIG. 2 is a diagram exemplarily showing structure of a storage request according to an example embodiment.
FIG. 3 is a diagram exemplarily showing structure of data according to an example embodiment.
FIG. 4 is a block diagram showing a hyper storage device according to an example embodiment.
FIG. 5 is a block diagram showing configuration of a CXL memory device according to an example embodiment.
FIG. 6 is a diagram showing operation of an application classifying circuit according to an example embodiment.
FIG. 7 is a block diagram showing a method of flushing a memory area according to an example embodiment.
FIG. 8 is a drawing showing a first storage area according to an example embodiment.
FIG. 9 is a flowchart showing an operating method of a CXL memory device according to an example embodiment.
FIG. 10 is a diagram showing operation of a memory area management circuit according to an example embodiment.
FIG. 11 is a block diagram showing configuration of a hyper storage device according to an example embodiment.

### DETAILED DESCRIPTION

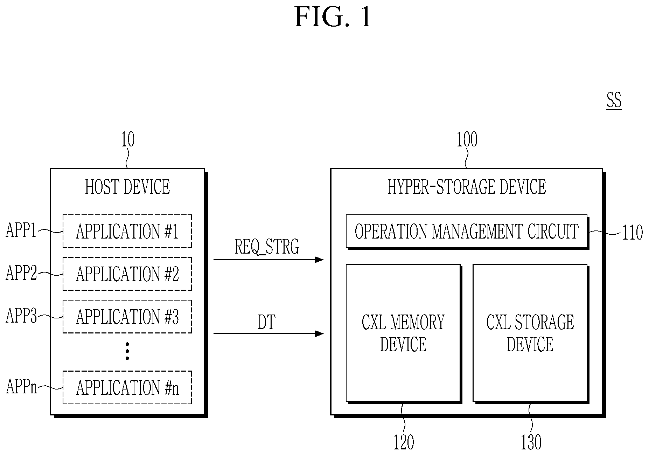

FIG. 1 is a block diagram showing a storage system according to an example embodiment. A storage system SS may include a host device 10 and a hyper storage device 100.

The host device 10 may execute a plurality of applications APP. For example, the host device 10 may execute the first to n-th applications APP1 to APPn. Each of the first to n-th applications APP1 to APPn may be one of various types of applications, such as operating system, user application, firmware, virtual machine, etc. However, example embodiments are not limited to the specific types of each of the first to n-th applications APP1 to APPn.

In an example embodiment, the host device 10 may include one or more of various processors, such as a central processing unit (CPU), a graphics processing unit (GPU), a neural processing unit (NPU), a data processing unit (DPU), etc.

In an example embodiment, the hyper storage device 100 may be a petabyte-scale solid state drive (PBSSD). For example, the hyper storage device 100 may be configured to store more than 1-petabyte of data. However, example embodiments are not limited thereto.

The host device 10 may access the hyper storage device 100. For example, the host device 10 may store data in the hyper storage device 100 or read data stored in the hyper storage device 100. For example, the host device 10 may issue a storage request REQ_STRG to store data DT issued from one of the first to n-th applications APP1 to APPn in the hyper storage device 100. Hereinafter, an example embodiment in which the host device 10 stores data in the hyper storage device 100 will be mainly described.

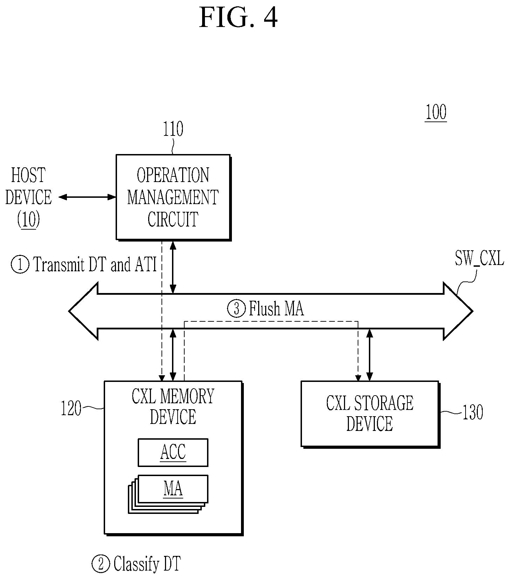

The hyper storage device 100 may include a operation management circuit 110, a compute express link (CXL) memory device 120, and a CXL storage device 130. The operation management circuit 110, the CXL memory device 120, and the CXL storage device 130 may communicate with each other based on a CXL interface. The manner in which the operation management circuit 110, the CXL memory device 120, and the CXL storage device 130 communicate is described in more detail with reference to FIG. 4 below.

The operation management circuit 110 may control overall operations of the hyper storage device 100. For example, the operation management circuit 110 may control the CXL memory device 120 and the CXL storage device 130 based on a request provided from the host device 10. For example, the operation management circuit 110 may control the CXL memory device 120 to store data DT in the CXL storage device 130 in response to a storage request REQ_STRG.

The CXL memory device 120 may buffer the data DT. For example, the CXL memory device 120 may temporarily store the data DT provided from the host device 10. The CXL memory device 120 may flush the temporarily stored data DT to the CXL storage device 130. In this way, the CXL storage device 130 may store data DT provided from the host device 10.

In an example embodiment, the CXL memory device 120 may identify a source application (i.e., "APP_source") of data DT. For example, the CXL memory device 120 may identify which application APP within the host device 10 has issued the data DT. The CXL memory device 120 may flush the data DT to a storage area within the CXL storage device 130, which is determined according to the source application APP _source of the data DT. Therefore, according to an example embodiment, the storage area within the CXL storage device 130 where the data DT is stored may be varied depending on that which application APP has issued the data DT. In this regard, the CXL memory device 120 may distribute a plurality of data DT provided from the host device 10 to different storage areas, based on which source application APP _source provides the data DT. In this case, because data DT may be stored in an organized form within the hyper storage device 100, the operational efficiency of the hyper storage device 100 may be improved.

In an example embodiment, the CXL memory device 120 may be a volatile memory device, such as a dynamic random-access memory (DRAM) device, and the CXL storage device 130 may be a nonvolatile memory device, such as a solid state drive (SSD).

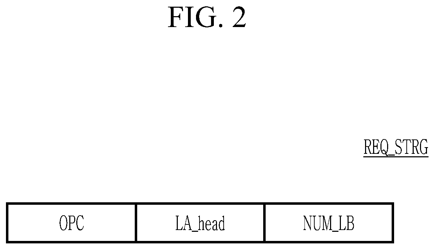

FIG. 2 is a diagram exemplarily showing the structure of a storage request of FIG. 1. Referring to FIGS. 1 and 2, the storage request REQ_STRG may include an operation code OPC, a head logical address LA_head, and a number of logical blocks NUM_LB.

The operation code OPC may indicate that the request provided to the hyper storage device 100 is a storage request REQ_STRG. The head logical address LA_head may indicate a logical address (more specifically, a start value of a logical address range) within the host device 10 of data DT, which is transmitted along with the storage request REQ_STRG. The number of logical blocks NUM_LB may indicate how many logical blocks within the host device 10 corresponds to the data DT transmitted along with the storage request REQ_STRG. That is, the number of logical blocks NUM_LB may represent the capacity of data DT transmitted together with the storage request REQ_STRG.

In an example embodiment, the storage request REQ_STRG may further include a data pointer indicating a location within the host device 10 where the data DT is stored. However, example embodiments are not limited thereto.

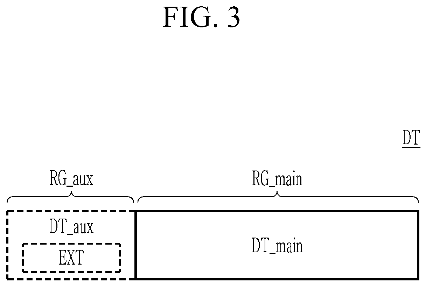

FIG. 3 is a diagram exemplarily showing the structure of the data of FIG. 1. Referring to FIGS. 1 to 3, data DT may include a main data region RG_main and an auxiliary data region RG_aux. The main data region RG_main may include a bit stream. The bit stream included in the main data region RG_main may be referred to as main data DT_main.

The auxiliary data region RG_aux may include a bit stream. The bit stream included in the auxiliary data region RG_main may be referred to as an auxiliary data DT_aux. Auxiliary data DT_aux may include an extension EXT (e.g., file extension) of the data DT. However, example embodiments are not limited thereto, and the auxiliary data DT_aux may include various types of metadata, such as a source application identifier indicating a source application (or a group identifier indicating a group of applications including the source application) corresponding to the data DT.

In an example embodiment, the data DT may not include the auxiliary data region RG_aux. For example, depending on the type of application that issued the data DT, the data DT may include only the main data region RG_main.

In an example embodiment, the storage request REQ_STRG and the data DT may not include information (e.g., a source application identifier) about the source application APP_source of the data DT. For example, the storage request REQ_STRG and data DT may not include information indicating which application APP has issued the data DT. In this case, because the host device 10 may not be needed to manage information about the application which has issued the data DT, the operating load of the host device 10 may be reduced. However, example embodiments are not limited thereto, and the storage request REQ_STRG or data DT may include the source application identifier.

In an example embodiment, the storage request REQ_STRG and the data DT may not include an identifier defining the classification of the data DT. For example, the storage request REQ_STRG and data DT may not include information such as namespace identifiers, stream identifiers, etc. In this case, because the host device 10 may not be needed to manage the namespace and stream, the operating load of the host device 10 may be reduced. However, example embodiments are not limited thereto, and the storage request REQ_STRG or data DT may include the namespace identifier or the stream identifier.

FIG. 4 is a block diagram showing the hyper storage device of FIG. 1 in more detail. Referring to FIGS. 1 to 4, the hyper storage device 100 may include the operation management circuit 110, the CXL memory device 120, and the CXL storage device 130. The operation management circuit 110, the CXL memory device 120, and the CXL storage device 130 may communicate with each other through the CXL switch SW_CXL.

In an example embodiment, the CXL switch SW_CXL may support communication among the operation management circuit 110, the CXL memory device 120, and the CXL storage device 130 based on the CXL interface.

In an example embodiment, the CXL interface may refer to a low-latency, high-bandwidth link that supports dynamic protocol multiplexing (or muxing) of coherency, memory access, and IO protocols to enable diverse connections between accelerators, memory devices, or various electronic devices.

In an example embodiment, the CXL memory device 120 and the CXL storage device 130 may be connected to the CXL switch SW_CXL based on same form-factor. For example, each of the CXL memory device 120 and the CXL storage device 130 may be connected to a PCIe slot implemented on the CXL switch SW_CXL.

The operation management circuit 110 may support communication between the hyper storage device 100 and the host device 10. That is, the hyper storage device 100 may communicate with the host device 10 through the operation management circuit 110. For example, the operation management circuit 110 may receive a storage request REQ_STRG and data DT from the host device 10.

In an example embodiment, the operation management circuit 110 may communicate with the host device 10 based on at least one of various host interfaces, such as a compute express link (CXL) interface, a Peripheral Component Interconnect express (PCIe) interface, a nonvolatile memory express (NVMe) interface, and the like.

The operation management circuit 110 may control overall operations of the hyper storage device 100. For example, based on a storage request REQ_STRG, the operation management circuit 110 may control the CXL memory device 120 and the CXL storage device 130 through the CXL switch SW_CXL.

For brevity, the operation management circuit 110 is illustrated in FIG. 4 as a separate component from the CXL switch SW_CXL, but example embodiments are not limited thereto. For example, the operation management circuit 110 may be included in the CXL switch SW_CXL. That is, example embodiments are not limited to the specific implementation method of the operation management circuit 110 and the CXL switch SW_CXL.

The operation management circuit 110 may generate an attribute information ATI based on a storage request REQ_STRG received together with data DT. The attribute information ATI may include a head logical address LA_head corresponding to the data DT and a capacity information of the data DT.

The operation management circuit 110 may provide the data DT and attribute information ATI corresponding thereto to the CXL memory device 120 in response to the storage request REQ_STRG (① Transmit DT and ATI).

The CXL memory device 120 may receive the data DT and attribute information ATI corresponding thereto. The CXL memory device 120 may include an application classifying circuit ACC. An application classifying circuit ACC may identify (e.g., perform inference) a source application APP_source for the data DT, based on the data DT and the attribute information ATI corresponding thereto. The application classifying circuit ACC may classify the data DT based on the source application APP_source (② Classify DT). That is, the application classifying circuit ACC may classify data DT based on which of the plurality of applications APP has issued the data DT.

The CXL memory device 120 may include a plurality of memory areas MA. The CXL memory device 120 may determine a memory area MA for temporarily storing (e.g., buffer) the data DT, based on the source application APP_source. That is, the CXL memory device 120 may determine a memory area MA differently to temporarily store the data DT based on which application has issued the data DT. That is, the CXL memory device 120 may temporarily store data DT issued from different applications APP in different memory areas MA.

In an example embodiment, the application classifying circuit ACC may identify a source application APP_source of the data DT based on the contents of the data DT. For example, the application classifying circuit ACC may infer the source application APP _source of the data DT by analyzing the bit stream of the main data region RG_main of the data DT.

In an example embodiment, the data DT may include an auxiliary data region RG_aux. In this case, the application classifying circuit ACC may identify the source application APP _source of the data DT based on the auxiliary data region RG_aux. For example, the application classifying circuit ACC may infer the source application APP_source of data DT based on an extension EXT included in the auxiliary data region RG_aux.

In an example embodiment, the application classifying circuit ACC may identify a source application APP_source of data DT based on the attribute information ATI. For example, the application classifying circuit ACC may infer the source application APP_source of the data DT based on a capacity information of the data DT and the head logical address LA_head of the data DT.

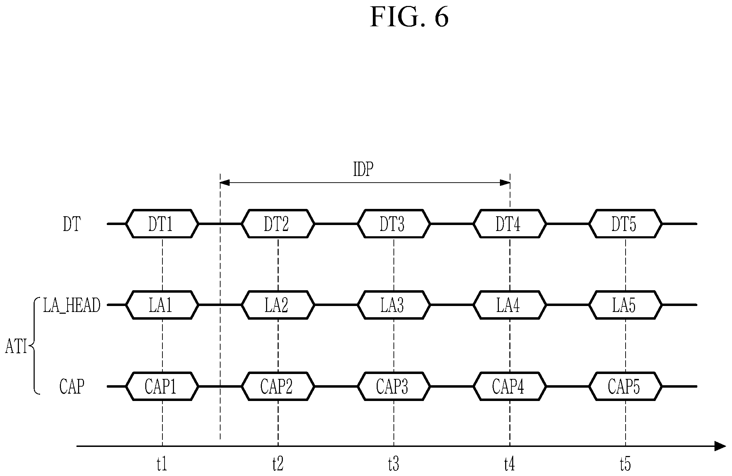

In an example embodiment, the application classifying circuit ACC may identify a source application APP_source of the data DT based on other data provided prior to the data DT. For example, the application classifying circuit ACC may infer the source application APP_source of the data DT based on various information such as attribute information, main data, extension, etc., of other data provided to the CXL memory device 120 prior to the data DT. The way in which the application classifying circuit ACC infers the source application APP_source based on other data provided prior to the data DT will be described in more detail with reference to FIG. 6 below.

In an example embodiment, the application classifying circuit ACC may also be configured to infer the source application APP_source of the data DT based on two or more of the methods described above. For example, the application classifying circuit ACC may infer a source application APP_source for the data DT based on a combination of two or more of i) bit stream of a main data region RG_main of the data DT, ii) bit stream of an auxiliary data region RG_aux of the data DT, iii) an extension EXT of the data DT, iv) a capacity information of the data DT, v) a head logical address LA_head of the data DT, and vi) information about other data provided to the CXL memory device 120 prior to the data DT. That is, example embodiments are not limited to a specific method in which the application classifying circuitACC infers a source application APP _source for data DT.

In an example embodiment, both of the storage request REQ_STRG and the data DT may not include an identifier indicating a source application APP_source (or an identifier indicating application group that includes the source application APP _source). For example, an application identifier may not be provided in the storage request REQ_STRG or in data DT. That is, the application classifying circuit ACC may infer the source application APP_source of the data DT even though the storage request REQ_STRG and the data DT do not include identifier indicating the source application APP_source. In this case, because the host device 10 may not manage information about an application which has issued the data DT, the operating load of the host device 10 may be reduced. However, example embodiments are not limited thereto. For example, the storage request REQ_STRG or the data DT may include an application identifier indicating the source application APP_source. In this case, the application classifying circuit ACC may be able to classify data DT based on the application identifier.

In an example embodiment, an identifier defining the classification of the data DT may not be included in the storage request REQ_STRG or the data DT. For example, both the storage request REQ_STRG and the data DT may not include a namespace identifier or a stream identifier. That is, the application classifying circuit ACC may infer the source application APP _source of data DT even though the storage request REQ_STRG and data DT do not include a namespace identifier and the storage request REQ_STRG and data DT do not include a stream identifier. In this case, the operating load of the host device 10 may be reduced because the host device 10 may not manage the namespace and stream of the hyper storage device. However, example embodiments are not limited thereto. For example, the storage request REQ_STRG or the data DT may include one or more of namespace identifier and stream identifier. In this case, the application classifying circuitACC may be able to infer the source application APP _source of the data DT based on one or more of the namespace identifier and the stream identifier.

The CXL memory device 120 may flush a specific memory area MA to the CXL storage device 130 (③ Flush MA). That is, the CXL memory device 120 may store a plurality of data DT stored in the specific memory area MA in a batch to the CXL storage device 130. In this way, the CXL memory device 120 may buffer data DT provided from the host device 10 and then store it in the CXL storage device 130. Therefore, according to an example embodiment, a plurality of data corresponding to one application may be stored in a CXL storage device 130 collectively (e.g., at once).

In an example embodiment, the CXL memory device 120 may flush a specific memory area MA to the CXL storage device 130 in a peer-to-peer (P2P) manner. For example, the CXL memory device 120 may directly provide the plurality of data DT stored in the specific memory area MA to the CXL storage device 130 through the CXL switch SW_CXL. In this regard, the CXL memory device 120 may provide data directly to the CXL storage device 130 without going through the operation management circuit 110.

In an example embodiment, the CXL memory device 120 may flush a specific memory area MA to the CXL storage device 130 when the specific memory area MA is in a full-state. However, example embodiments are not limited thereto, and the CXL memory device 120 may also be configured to flush the specific memory area MA to the CXL storage device 130 in response to the control of the operation management circuit 110.

In an example embodiment, memory area MA may be referred to as being in a full-state when a ratio of the sum of the capacities of one or more data stored in the specific memory area MA to the capacity of the specific memory area MA is greater than a predetermined ratio (e.g., 90%). However, example embodiments are not limited thereto.

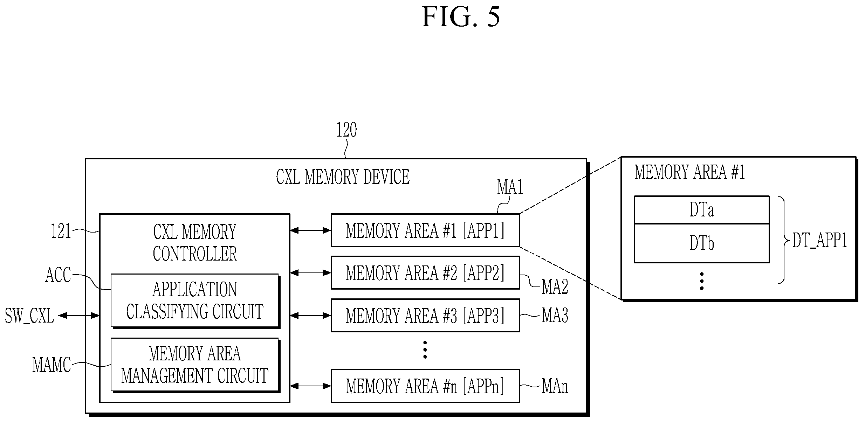

FIG. 5 is a block diagram showing the configuration of the CXL memory device of FIG. 4 in more detail. Referring to FIGS. 1 to 5, the CXL memory device 120 may include a CXL memory controller 121 and first to n-th memory areas MA1 to MAn.

Each of the first to n-th memory areas MA1 to MAn may correspond to different application. For example, the first to n-th memory areas MA1 to MAn may correspond to the first to n-th applications APP1 to APPn, respectively.

The CXL memory controller 121 may control overall operations of the CXL memory device 120. For example, the CXL memory controller 121 may sequentially receive a plurality of data DT from the operation management circuit 110 through the CXL switch SW_CXL, and may transmit the plurality of data DT to the CXL storage device 130 through the CXL switch SW_CXL.

The CXL memory controller 121 may include an application classifying circuit ACC and a memory area management circuit MAMC.

The application classifying circuit ACC may infer the source application APP_source of data DT provided to the CXL memory controller 121. The application classifying circuit ACC may store data DT in one of the first to n-th memory areas MA1 to MAn based on the inferred source application APP_source. For example, the application classifying circuit ACC may temporarily store data DT in a memory area MA corresponding to the source application APP_source.

For example, the application classifying circuit ACC may infer a first application APP1 as the source application APP_source for the first data DTa. In this case, the application classifying circuit ACC may store the first data DTa in the first memory area MA1. As another example, the application classifying circuit ACC may infer the second application APP2 as the source application APP_source for the second data DTb. In this case, the application classifying circuit ACC may store the second data DTb in a second memory area MA2. In this way, the application classifying circuit ACC may distribute (e.g., store) a plurality of data DT provided to the CXL memory controller 121 into the first to n-th memory areas MA1 to MAn.

In an example embodiment, a plurality of data DT stored in the first to n-th memory areas MA1 to MAn may be referred to as first to n-th application data DT_APP1 to DT_APPn, respectively. For example, each of data DT stored in the first memory area MA1 may be referred to as first application data DT_APP1.

The memory area management circuit MAMC may manage a size of each of the first to n-th memory areas MA1 to MAn. For example, the memory area management circuit MAMC may increase or decrease the size of each of the first to n-th memory areas MA1 to MAn, in response to the control of the operation management circuit 110.

In an example embodiment, the operation management circuit 110 may receive a quality of service (QoS) level required for each of the first to n-th applications APP1 to APPn from the host device 10. In this case, the operation management circuit 110 may control, based on the QoS level required for each of the first to n-th applications APP1 to APPn, the memory area management circuit MAMC to increase or decrease the size of each of the first to n-th memory areas MA1 to MAn.

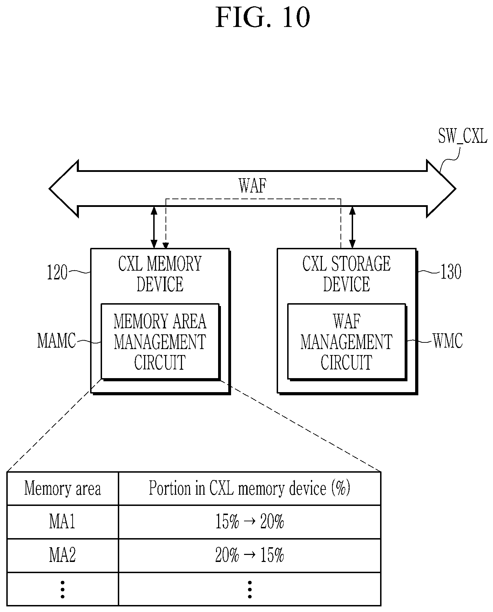

In an example embodiment, the memory area management circuit MAMC may increase or decrease the size of each of the first to n-th memory areas MA1 to MAn based on a write amplification factor provided from the CXL storage device 130. An example embodiment in which the memory area management circuit MAMC adjusts the size of each of the first to n-th memory areas MA1 to MAn based on the write amplification factor will be described in more detail with reference to FIG. 10 below.

In an example embodiment, as the capacity of a specific memory area MA increases, the CXL memory device 120 may buffer a relatively larger amount of data DT in the memory area MA. In this case, because a relatively larger amount of data DT may be stored in the CXL storage device 130 collectively, a plurality of data DT may be stored in more appropriately organized form within the CXL storage device 130. Therefore, the operational efficiency of the CXL storage device 130 may be improved. For example, as a plurality of data DT are stored in a more appropriately organized form within the CXL storage device 130, data fragmentation of the CXL storage device 130 may be reduced and garbage collection efficiency may be improved. In this case, the write amplification factor of the CXL storage device 130 may be reduced, so the operating efficiency and lifespan of the CXL storage device 130 may be improved.

In an example embodiment, before the CXL memory controller 121 flushes data DT provided from the host device 10 to the CXL storage device 130, the host device 10 may access the data DT. In this case, the CXL memory controller 121 may provide data DT read from one of the first to n-th memory areas MA1 to MAn to the host device 10 in response to the control of the operation management circuit 110. In this regard, when data DT is stored in the CXL memory device 120, the CXL memory device 120 may provide the data DT to the host device 10 without accessing the CXL storage device 130. In this case, the operating speed of the hyper storage device 100 may be improved. The larger the specific memory area MA is, the more data DT may be stored in the memory area MA, and the operating performance of the hyper storage device 100 perceived by the application APP corresponding to the memory area MA may be improved. However, example embodiments are not limited thereto.

FIG. 6 is a diagram showing the operation of the application classifying circuit of FIG. 4 according to an example embodiment. Referring to FIGS. 1 to 6, the application classifying circuit ACC may receive first to fifth data DT1 to DT5, and corresponding attribute information ATI thereto at first to fifth time points t1 to t5, respectively. For example, the attribute information ATI may include head logical addresses LA_head and capacity information CAP. The head logical addresses LA_head may include the first to fifth logical addresses LA1 to LA5, and the capacity information CAP may include the first to fifth capacity information CAP1 to CAP5. The application classifying circuit ACC may receive the first to fifth logical addresses LA1 to LA5 at the first to fifth time points DT1 to DT5, respectively; and may receive the first to fifth capacity information CAP1 to CAP5 at the first to fifth time points DT1 to DT5, respectively.

The application classifying circuit ACC may infer a source application APP_source corresponding to a specific data DT based on other data DT and attribute information ATI received during an identification period IDP corresponding to the time point when the data DT was received. Hereinafter, for a more concise explanation, an exemplary scheme in which the application classifying circuit ACC infers the source application APP_source corresponding to the fourth data DT4 will be described.

The application classifying circuit ACC may determine an identification period IDP for the fourth time point t4 when the fourth data DT4 is received. For example, the application classifying circuit ACC may determine, as an identification period IDP, the time interval between the fourth time point t4 and a time point that precedes the fourth time point t4 as a predetermined time length. The application classifying circuit ACC may infer the source application APP_source corresponding to the fourth data DT4 based on the second to fourth data DT2 to DT4, the second to fourth logical addresses LA2 to LA4, and the second to fourth capacity information CAP2 to CAP4, which are received during the identification period IDP. That is, the application classifying circuit ACC may infer the source application APP_source corresponding to the fourth data DT4 based on one or more of various information, such as the bit stream of the main data region RG_main, the bit stream of the auxiliary data region RG_aux, the extension EXT, the capacity information CAP, and the head logical address LA_head of each of the second to fourth data DT2 to DT4. However, example embodiments are not limited thereto. For example, the application classifying circuit ACC may infer the source application APP_source corresponding to the fourth data DT4 only based on the fourth data DT4 and the attribute information ATI corresponding to the fourth data DT4.

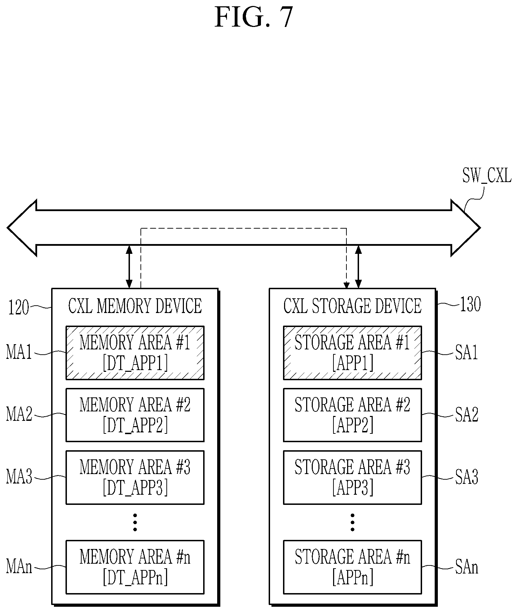

FIG. 7 is a block diagram showing in more detail the method of flushing the memory area of FIG. 4. Referring to FIGS. 1 to 7, the CXL memory device 120 may include first to n-th memory areas MA1 to MAn. The first to n-th memory areas MA1 to MAn may store the first to n-th application data DT_APP1 to DT_APPn, respectively.

The CXL storage device 130 may include first to n-th storage areas SA1 to SAn. Each of the first to n-th storage areas SA1 to SAn may correspond to a different memory area MA. For example, the first to n-th storage areas SA1 to SAn may correspond to the first to n-th memory areas MA1 to MAn, respectively.

Each of the first to n-th storage areas SA1 to SAn may be configured to store a plurality of data DT flushed from corresponding memory area MA. For example, the first to n-th storage areas SA1 to SAn may be storage spaces allocated for the first to n-th application data DT_APP1 to DT_APPn, respectively. That is, the first to n-th storage areas SA1 to SAn may store data issued from the first to n-th applications APP1 to APPn, respectively.

The CXL memory device 120 may determine to flush a specific memory area MA. For example, when the first memory area MA1 is in full-state, the CXL memory device 120 may determine to flush the first memory area MA1. Alternatively, the CXL memory device 120 may determine to flush the first memory area MA1 in response to control of the operation management circuit 110. Hereinafter, an example embodiment in which the CXL memory device 120 flushes the first memory area MA1 will be representatively described. However, example embodiments are not limited thereto.

The CXL memory device 120 may flush the first memory area MA1 to the first storage area SA1. For example, the CXL memory device 120 may store one or more first application data DT_APP1 stored in a first memory area MA1 into the first storage area SA1, by accessing the CXL storage device 130 in a P2P manner.

In an example embodiment, the CXL memory device 120 may provide a storage area identifier indicating the first storage area SA1 to the CXL storage device 130 along with the one or more first application data DT_APP1. In this case, the CXL storage device 130 may store one or more first application data DT_APP1 in the first storage area SA1, based on a storage area identifier indicating the first storage area SA1. In this way, the CXL memory device 120 may store data in a specific storage area SA of the CXL storage device 130.

In an example embodiment, the CXL memory device 120 may provide, to the CXL storage device 130, the one or more first application data DT_APP1 along with logical address corresponding to each of the one or more first application data DT_APP1.

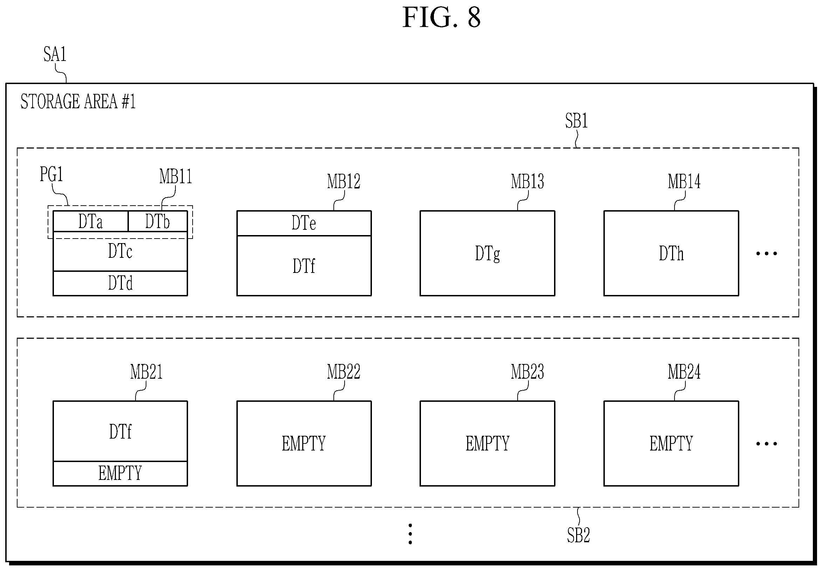

FIG. 8 is a drawing showing the first storage area of FIG. 7 in more detail. Hereinafter, for a more concise explanation, the configuration of the first storage area SA1 will be representatively described with reference to FIGS. 1 to 8. However, example embodiments are not limited thereto, and the second to n-th storage areas SA2 to SAn may also be implemented in a similar manner.

The first storage area SA1 may include one or more super blocks SB. For example, the first storage area SA1 may include a first super block SB1 and a second super block SB2.

Each of one or more super blocks SB may include a plurality of memory blocks MB. For example, the first super block SB1 may include memory blocks MB11 to MB14, and a second super block SB2 may include memory blocks MB21 to MB24.

The CXL storage device 130 may perform garbage collection operations in units of super blocks SB. For example, the CXL storage device 130 may perform a garbage collection operation on the first super block SB1 by reading valid data DT stored in a plurality of memory blocks MB included in the first super block SB1, erasing all memory blocks MB included in the first super block SB1, and then newly storing the read valid data DT in an arbitrary super block SB (e.g., one or more memory blocks MB in another super block SB included in the first storage area SA1, or else).

The CXL memory device 120 may flush the first to ninth data DTa to DTi to the first storage area SA1 collectively. For example, when the first to ninth data DTa to DTi are stored in the first memory area MA1, the CXL memory device 120 may flush the first to ninth data DTa to DTi all at once to the first storage area SA1.

Each of the plurality of memory blocks MB included in the first storage area SA1 may be implemented to store data DT. For example, the memory block MB11 may store the first to fourth data DTa to DTd; the memory block MB12 may store the fifth to sixth data DTe to DTf; the memory block MB13 may store the seventh data DTg; and the memory block MB14 may store the eighth data DTh. Similarly, the memory block MB21 may store the ninth data DTi. In this case, all of the first to ninth data DTa to DTi may be first application data DT_APP1.

In an example embodiment, the capacity of each of the first data DTa and the second data DTb may be smaller than one page PG. If the first data DTa and the second data DTb are stored in the CXL storage device 130 at different time points, the CXL storage device 130 may store the first data DTa and the second data DTb in different pages. In this case, because data DT of a size smaller than the capacity of a page PG is stored in one page PG, data fragmentation of the CXL storage device 130 (and further, data fragmentation of the hyper storage device 100) may increase. In contrast, according to an example embodiment, the CXL memory device 120 may flush the first data DTa and the second data DTb simultaneously to the first storage area SA1. In this case, because the first data DTa and the second data DTb may be stored in one page PG, data fragmentation and write amplification of the CXL storage device 130 (and further, data fragmentation and write amplification of the hyper storage device 100) may be minimized.

According to an example embodiment, a plurality of data DT stored in one super block SB may correspond to the same application. For example, all of the first to eighth data DTa to DTh may be data issued from the first application APP1. In this case, even if the first application APP1 issues a deletion request (e.g., trim request) for some data DT (e.g., two or more data), the possibility that such data DT are distributed across a plurality of super blocks SB (or the extent that such data are distributed across a plurality of super blocks SB) may be minimized. For example, the first application APP1 may issue a deletion request for the first to sixth data DTa to DTf. In this case, unlike the case where the first to sixth data DTa to DTf are stored in different super blocks because the first to sixth data DTa to DTf are stored in the CXL storage device 130 at different time points, according to an example embodiment, the CXL storage device 130 may be able to erase the first to sixth data DTa to DTf only by performing a garbage collection operation on the first super block SB1. Therefore, according to an example embodiment, the CXL storage device 130 may perform garbage collection operation more efficiently, so that write amplification of the CXL storage device 130 may be minimized.

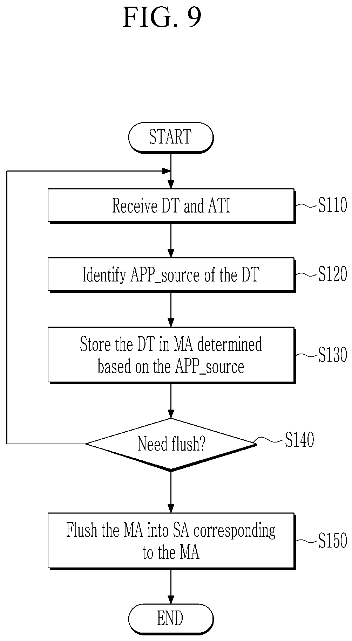

FIG. 9 is a flowchart showing an operating method of a CXL memory device according to an example embodiment. Referring to FIGS. 1 to 9, at operation S110, the CXL memory device 120 may receive data DT and attribute information ATI.

At operation S120, the CXL memory device 120 may identify the source application APP_source of the data DT. For example, the application classifying circuit ACC may infer the source application APP_source for the data DT by analyzing the attribute information ATI and data DT. However, example embodiments are not limited thereto, and the application classifying circuit ACC may also infer the source application APP_source for the data DT based on other data and attribute information received prior to the above-described operation S110, in the manner described above with reference to FIG. 6.

At operation S130, the CXL memory device 120 may store data DT in a memory area MAdetermined based on the source application APP _source. For example, if a first application APP1 is identified as the source application APP_source for data DT, the application classifying circuit ACC may store the data DT in a first memory area MA1 corresponding to the first application APP1.

At operation S140, the CXL memory device 120 may determine whether a flush is required. For example, the CXL memory device 120 may determine whether the memory area MA, in which data DT is newly stored at operation S130, is in a full-state. If it is determined that the flush is needed (i.e., that the memory area MA is in the full-state) at operation S140, operation S150 below may be performed. If it is determined that flush is not needed (i.e., that the memory area MA is not in the full-state) at operation S140, the above-described operation S110 may be performed repeatedly. In this way, the CXL memory device 120 may sequentially receive a plurality of data DT issued from the host device 10, and store the plurality of data DT in a distributed manner in a plurality of memory areas MA based on the source application APP_source for each of the plurality of data DT.

At operation S150, the CXL memory device 120 may flush the memory area MA to the storage area SA corresponding to the memory area MA. For example, if it is determined that flushing is needed for the first memory area MA1, the CXL memory device 120 may flush one or more first application data DP_APP1 stored in the first memory area MA1 to the first storage area SA1. Therefore, according to an example embodiment, only first application data DP_APP1 may be stored in the first storage area SA1.

FIG. 10 is a diagram showing the operation of the memory area management circuit of FIG. 5 according to an example embodiment. Referring to FIGS. 1 to 10, the CXL memory device 120 may include a memory area management circuit MAMC, and the CXL storage device 130 may include a write amplification factor management circuit WMC.

The write amplification factor management circuit WMC may measure a write amplification factor WAF for each of a plurality of storage areas SA included in the CXL storage device 130. For example, the write amplification factor management circuit WMC may calculate a value obtained by dividing the total capacity of data for which a write request for the first storage area SA1 has been received, by the total capacity of data for which a write operation has been performed for the first storage area SA1, as a write amplification factor WAF for the first storage area SA1.

The write amplification factor management circuit WMC may provide the write amplification factor WAF for each of a plurality of storage areas SA to the CXL memory device 120. However, example embodiments are not limited thereto, and the write amplification factor management circuit WMC may also be configured to compute one write amplification factor WAF for the CXL storage device 130. In this case, the write amplification factor management circuit WMC may provide the one write amplification factor WAF for the CXL storage device 130 to the CXL memory device 120.

A memory area management circuit MAMC may adjust the capacity of the plurality of memory areas MA based on the write amplification factor WAF for each of the plurality of storage areas SA.

For example, if a write amplification factor WAF for the first storage area SA1 is excessively high (e.g., higher than a predetermined first threshold value), the memory area management circuit MAMC may increase the capacity of the first memory area MA1. For example, the memory area management circuit MAMC may increase the portion of the first memory area MA1 in the CXL memory device 120 from 15% to 20%. In this case, as the capacity of the first memory area MA1 increases, the capacity of data collectively stored in the first storage area SA1 may increase, and thus the write amplification factor WAF for the first storage area SA1 may decrease.

For another example, if the write amplification factor WAF for the second storage area SA2 is sufficiently low (e.g., lower than a predetermined second threshold value), the memory area management circuit MAMC may reduce the capacity of the second memory area MA2. For example, the memory area management circuit MAMC may reduce the portion of the second memory area MA2 in the CXL memory device 120 from 20% to 15%. In this case, as the capacity of the second memory area MA2 decreases, the margin for expansion of other memory areas may increase.

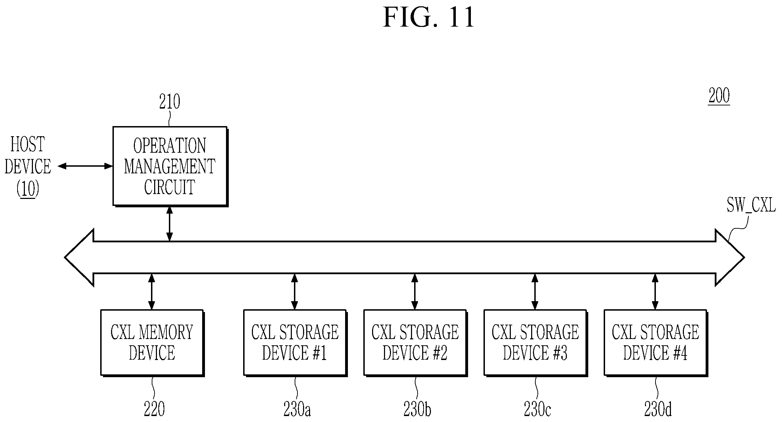

FIG. 11 is a block diagram showing the configuration of the hyper storage device of FIG. 1 according to an example embodiment. Referring to FIGS. 1 to 11, the hyper storage device 100 of FIG. 1 may be implemented as the hyper storage device 200 of FIG. 11.

The hyper storage device 200 may include an operation management circuit 210, a CXL memory device 220, and first to fourth CXL storage devices 230a to 240d. The operation management circuit 210, the CXL memory device 220, and the first to fourth CXL storage devices 230a to 240d may communicate with each other through a CXL switch SW_CXL. The configuration and operation of the operation management circuit 210, the CXL memory device 220, and the CXL switch SW_CXL are similar to those described above with reference to FIGS. 1 to 10, so a detailed description is omitted. For a more concise explanation, four CXL storage devices 230 are illustrated in FIG. 11, but example embodiments are not limited to the number of CXL storage devices 230 included in the hyper storage device 200.

In an example embodiment, the host device 10 may recognize the hyper storage device 200 as a storage device having a capacity corresponding to the sum of the storage capacities of the first to fourth CXL storage devices 230a to 240d.

Each of the first to fourth CXL storage devices 230a to 240d may include one or more storage areas SA. In this case, a plurality of storage areas SA included in the first to fourth CXL storage devices 230a to 240d may correspond to different applications APP. For example, a first CXL storage device 230a may include a storage area corresponding to a first application APP1; a second CXL storage device 230b may include a storage area corresponding to a second application APP2; a third CXL storage device 230c may include a storage area corresponding to a third application APP3; and a fourth CXL storage device 230d may include a storage area corresponding to a fourth application APPd. However, example embodiments are not limited thereto, similar to what was described above with reference to FIGS. 1 to 9, each CXL storage device 230 may also configured to include two or more storage areas respectively corresponding to two or more applications.

The CXL memory device 220 may sequentially receive a plurality of data DT issued from the host device 10. The CXL memory device 220 may identify a source application APP_source for each of a plurality of data DT. The CXL memory device 220 may distribute a plurality of data DT to different storage areas based on the source application APP_source corresponding to each of the a plurality of data DT. For example, the CXL memory device 220 may flush one or more data DT corresponding to the first application APP1 to a storage area included in a first CXL storage device 230a, and may flush one or more data DT corresponding to a second application APP2 to a storage area included in a second CXL storage device 230b. In this way, the CXL memory device 220 may distribute a plurality of data DT to a plurality of CXL storage devices 230 based on the source application APP_source corresponding to each of the plurality of data DT. In this case, the size of each storage area SA may increase compared to examples in which one CXL storage device 130 includes all of the first to n-th storage areas SA1 to SAn.

## Claims

1. A hyper storage device (100) configured to communicate with a host device (10) executing a plurality of applications (APP1-APPn), the hyper storage device (100) comprising:
an operation management circuit (110) configured to receive a plurality of data (DT) from the host device (10);
a memory device (120) comprising a plurality of memory areas (MA), and an application classifying circuit (ACC) configured to control the plurality of data (DT) to be distributed to the plurality of memory areas (MA) based on a source application (APP_source) of each of the plurality of data (DT); and
one or more storage devices (130, 230) comprising a plurality of storage areas (SA) respectively corresponding to the plurality of memory areas (MA),
wherein the memory device (120) is configured to flush a first memory area (MA1), which is one of the plurality of memory areas (MA), to a first storage area (SA1), which is one of the plurality of storage areas (SA) and corresponds to the first memory area (MA1).

2. The hyper storage device of claim 1, wherein the plurality of applications (APP1-APPn) comprise a first application (APP1),
wherein the application classifying circuit (ACC) is configured to buffer a first plurality of data among the plurality of data (DT) in the first memory area (MA1), and
wherein the source application (APP_source) corresponding to the first plurality of data is the first application (APP1).

3. The hyper storage device of claim 1 or 2, wherein the plurality of applications (APP1-APPn) further comprise a second application (APP2),
wherein the plurality of memory areas (MA) comprises a second memory area (MA2),
wherein the application classifying circuit (ACC) is configured to buffer a second plurality of data among the plurality of data (DT) in the second memory area (MA2),
wherein the source application (APP_source) corresponding to the second plurality of data is the second application (APP2), and
wherein the memory device (120) is further configured to flush the second memory area (MA2) to a second storage area (SA2), which is one of the plurality of storage areas (SA) and corresponds to the second memory area (MA2).

4. The hyper storage device of any one of claims 1 to 3, wherein the memory device (120) further comprises a memory area management circuit (MAMC) configured to adjust capacities of the first memory area (MA1) and preferably the second memory area (MA2).

5. The hyper storage device (100) of claim 4, wherein the memory area management circuit (MAMC) is further configured to adjust the capacities of the first memory area (MA1) and preferably the second memory area (MA2), based on a write amplification factor (WAF) provided from the one or more storage devices (130, 230).

6. The hyper storage device (100) of any one of claims 1 to 5, wherein the one or more storage devices (130, 230) comprises a first storage device (230a),
wherein the first storage area (SA1) and preferably the second storage area (SA2) are included in the first storage device (230a) which is one of the one or more storage devices (130, 230), and
wherein each of the first storage area (SA1) and preferably the second storage area (SA2) comprises one or more super blocks (SB).

7. The hyper storage device (100) of any one of claims 1 to 6, wherein the one or more storage devices (130, 230) comprises a first storage device (230a) comprising the first storage area (SA1) and preferably a second storage device (230b) comprising the second storage area (SA2).

8. The hyper storage device (100) of any one of claims 1 to 7, wherein the memory device (120) is further configured to flush the first memory area (MA1) to the first storage area (SA1), based on the first memory area (MA1) being in a full-state.

9. The hyper storage device (100) of any one of claims 1 to 8, wherein the application classifying circuit (ACC) is further configured to identify a source application (APP_source) for a first data (DTa) among the plurality of data (DT) based on at least one of a main data region (RG_main) of the first data (DTa), a capacity (CAP) of the first data (DTa), and a first logical address (LA) corresponding to the first data (DTa).

10. The hyper storage device (100) of claim 9, wherein the application classifying circuit (ACC) is further configured to identify the source application (APP_source) for the first data (DTa) further based on an extension (EXT) included in an auxiliary data region (RG_aux) of the first data (DTa).

11. The hyper storage device (100) of claim 9 or 10, wherein the application classifying circuit (ACC) is further configured to identify the source application (APP_source) for the first data (DTa) based on a second data (DTb), which is provided to the memory device (120) prior to the first data (DTa) and which is one of the plurality of data (DT).

12. The hyper storage device (100) of any one of claims 1 to 11, further comprising a CXL switch (SW_CXL) connecting the operation management circuit (110), the memory device (120), and the one or more storage devices (130, 230).

13. The hyper storage device (100) of claim 12, wherein the memory device (120) and the one or more storage devices (130, 230) are configured to be connected to the CXL switch (SW_CXL) based on same form-factor.

14. An operation method of a memory device (120), the operation method comprising:
receiving (S110) a first data (DTa);
identifying (S120) a source application (APP_source) of the first data (DTa), wherein the source application (APP_source) is identified from among a plurality of source applications;
storing (S130) the first data (DTa) in a first memory area (MA1) among a plurality of memory areas (MA) determined based on the source application (APP_source), wherein the plurality of source applications respectively correspond to the plurality of memory areas (MA); and
flushing (S150) the first memory area (MA1) to an external storage device (130, 230).

15. The operation method of claim 14, wherein the identifying (S120) is performed based on at least one of a main data region (RG_main) of the first data (DTa), a capacity (CAP) of the first data (DTa), and a first logical address (LA) corresponding to the first data (DTa).
